Europäisches Patentamt

(19) European Patent Office

Office européen des brevets

(11) Publication number: **0 106 638**
**A1**

# (12) EUROPEAN PATENT APPLICATION

(21) Application number: 83306058.5

(22) Date of filing: 06.10.83

(51) Int. Cl.³: **C 23 C 11/00**
**C 23 C 11/08**
**//G02B1/10, G02B1/12**

(30) Priority: 12.10.82 GB 8229125

(43) Date of publication of application:
25.04.84 Bulletin 84/17

(84) Designated Contracting States:
CH DE FR LI NL

(71) Applicant: NATIONAL RESEARCH DEVELOPMENT CORPORATION
101 Newington Causeway
London SE1 6BU(GB)

(72) Inventor: Green, Geoffrey William
5 Piers Close Malvern
Worcestershire(GB)

(72) Inventor: Lettington, Alan Harold
86 Arundel Drive
Battenhall Worcester WR5 2NA(GB)

(74) Representative: Edwards, John Brian et al,
Procurement Executive Ministry of Defence Patents 1 A
(4), Room 2014 Empress State Building Lillie Road
London SW6 1TR(GB)

(54) Method and apparatus for growing material in a glow discharge.

(57) A method of growing a combined layer of at least a first and a second material in a glow discharge chamber (1). A target cathode (18) formed of the first material e.g. Si, Ge, W is arranged in the chamber (1) and spaced from a substrate (19) to be coated. Argon gas and a gas of the second material, e.g. a hydrocarbon, are admitted into the chamber and a glow discharge established. Hydrocarbon ions from the glow discharge plasma strike and deposit on the cathode target (18). Argon ions sputter off atoms of both C and bulk target material e.g. Si, Ge, or W, which deposit onto the substrate (19) and gradually build up a combined layer (24) of e.g. $Si_xC_{1-x}$, $Ge_xC_{1-x}$, $W_xC_{1-x}$.

EP 0 106 638 A1

- 1 -

## METHOD AND APPARATUS FOR GROWING MATERIAL IN A GLOW DISCHARGE

The invention relates to a method and apparatus for growing material in a glow discharge and to a material produced thereby.

Glow discharge growth techniques are known. For example a plasma is caused in a hydrocarbon gas inside an evacuated chamber. Carbon ions strike the cathode and adhere to form a carbon coating. For correct growth conditions the coating is extremely hard and substantially transparent to infra red radiation. Unfortunately internal stresses prevent growth of layers thicker than about $3 \mu m$ under these conditions. Interstitial carbon atoms in the layer absorb radiation at shorter wavelengths of the spectrum particularly in the visible regions and hydrogen in the films produce selective absorption. Coating of silicon using the gas silane and coatings of germanium using germane may also be grown in a glow discharge.

Sputtering is also a known technique. Argon ions inside a glow discharge chamber strike a target arranged as a cathode containing coating material. Atoms or atomic clusters are dislodged from the target and stick on a substrate arranged suitably near the target.

Glow discharge techniques are described in:-

Thin Film Solids 58 (1979) 101-105, 106, 107-116, 117-120;

Spear W. E., Doped Amorphous Semiconductor, Advances in Physics 1977, Vol 26, No. 6, 811-845;

Patent Specifications G.B. 2,047,877 A, 2,067,304 A; 2,069,008 A; 2,082,562 A; 2,083,841 A.

Patent Specification No. G.B. 2,069,009 A describes a growth technique in which a substrate is arranged above an aluminium cathode. Carbon ions strike the cathode, some adhere to the cathode and some bounce off and stick onto the substrate. A bias voltage may be applied to the substrate. This layer has a lower strain than similar layers deposited on cathodes but it still contains interstitial carbon.

According to this invention a method of growing a combined layer of at least a first and a second material comprisng the steps of arranging a first material forming a target material on a cathode in a glow discharge chamber, arranging a substate to be coated on a holder a spaced distance from the target, maintaining the substrate temperature at a required level, admitting elements of the second material and a sputtering material into the chamber, and establishing a glow discharge within the chamber, the glow discharge plasma containing ions of the second material for adhering to the target material and ions of the sputtering material that sputter off both the first material and second material onto the substrate, the arrangement being such that as molecules of the second material are deposited on the target molecules of both the first and second material are sputtered off to deposit on the substrate where a layer of the first and second material gradually builds up in thickness to the required value.

The sputtering ions may be argon ions.

The target material may be a single material or a mixture of materials such as silicon, germanium, tungsten or any other material capable of being sputtered and forming a compound or mixture with the second material

The second material may be carbon introduced as a hydrocarbon gas such as butane methane propane etc.

The substrate temperature may be at an elevated temperature e.g. above 300°C typically 530°C when using a hydrocarbon gas to prevent deposition of hydrogen on the substrate.

Additionally a third or further materials may be introduced into the chamber as a gas to grow a layer of at least three elements. In some cases an additional source of the first material may be introduced as a gas. For example when using a Ge target the gas germane may be bled into the chamber. This assists deposition of $Ge_xC_{1-x}$ onto the substrate. For a Si target silane is introduced.

After growth of the required layer the substrate may be removed or the layer left as a coating on the substrate.

The material grown may be $Si_xC_{1-x}$, $Ge_xC_{1-x}$, $W_xC_{1-x}$ (0 x 1) or any other suitable carbide or mixtures or carbides. The value of x may be changed across the thickness to the layer to provide a graded layer.

According to this invention apparatus for growing a layer of at least a first and a second material comprises a vacuum tight chamber, an anode, and a cathode structure including target material in the chamber, means for establishing a glow discharge in the chamber, a vacuum pump for evacuating the chamber, means for supplying gases into the chamber, and a substrate holder for supporting the substrate a spaced distance from the cathode, the arrangement being such that ion of one of the gases deposit on the cathode and both these and the target material are sputtered off to land on the substrate and build up as a layer of the required material.

When growing layers containing carbon using a hydrocarbon gas the substrate holder includes means for heating the substrate. This heating may be an electrical resistive heater or a susceptor and external R.F. coils. Typical substrate temperature is above 500°C. e.g. 530°C. The glow discharge may be energised by D.C. or A.C. (or any suitable frequency) power to the cathode, or by externally mounted R.F. coils.

The invention will now be described by way of example only with reference to the accompanying drawings of which:-

Figure 1 is a sectional view of glow discharge apparatus for growing a layer on a substrate;

Figure 2 is a sectional view of a substrate coated by the apparatus of Figure 1.

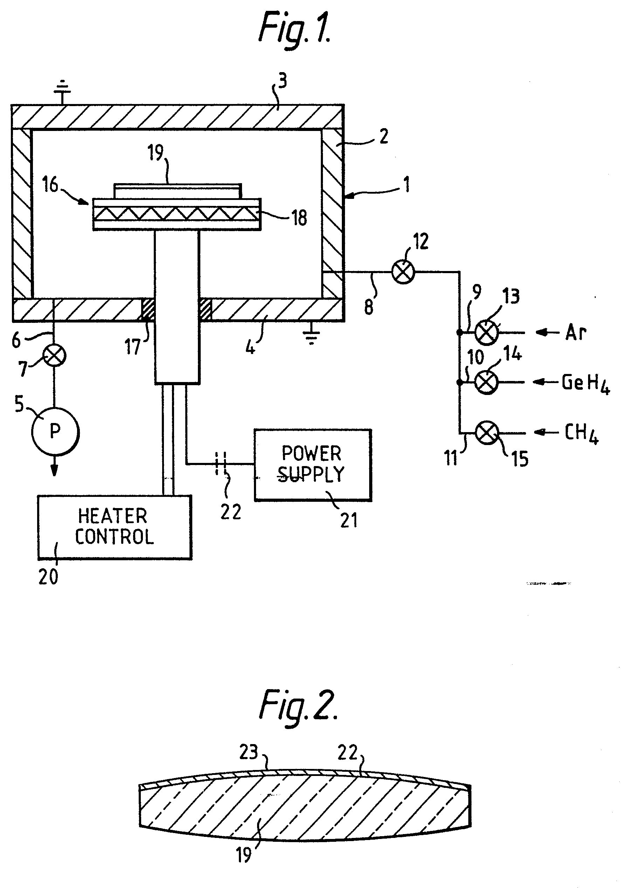

The apparatus of Figure 1 comprises a pressure tight chamber 1 formed by an annular wall 2 closed by earthed top and bottom plates 3, 4 respectively. The plates 3, 4 form anodes. A vacuum pump 5 is connected by a pipe 6 and valve 7 to evacuate the chamber 1 and maintain a desired vacuum during growth. Supplies of gases e.g. argon and a hydrocarbon gas such as butane, or gases such as silane, or germane are bled into the chamber 1 via valves 8, 9, 10 and pipes 11, 12, 13. A cathode structure 14 is mounted in the chamber 1 and electrically isolated from the bottom plate 4 by a sleeve 15. Electrical power is supplied to the cathode 14 by a power source 16. For an A.C. supply this is through a capacitor 17, a D.C. supply needs no capacitor.

A piece of material 18 such as silicon, germanium, etc. is located on the upper surface of the cathode structure 14 to form the target. Above the target 18 a substrate 19 is held by a holder 20 electrically isolated from the top plate 3 by a sleeve 21. Inside the holder 20 is an electrical resistance heater 22 supplied with power from a heater control/power supply 23. The substrate 19 forms a support on which a layer 24 of the required material is grown. It may be regular, flat or curved, or irregular. To ensure even coating of a substrate 19 it may be rotated with or by the holder 20.

Operation to grow $Si_xO_{1-x}$ is as follows. A target material 18 of silicon is mounted on the cathode 14 to form the cathide in a glow discharge. A thin substrate 19 of aluminium is fixed to the holder 20. The chamber 1 is evacuated to about $10^{-5}$ Torr. to remove contaminants. Argon and butane gas is bled into the chamber through the valves 8, 9, 10, and the pump 5 operated to maintain a pressure of about 0.7 to $1 \times 10^{-2}$ Torr. on an air calibrated gauge. The substrate 19 is heated to about $550°C$. and maintained at this temperature during growth of the layer 24.

R.F. power of typically 1 Kvolt, 13 MHz. and 200 watts power is supplied to the cathode 14, 18. This ionises the gas mixture. Positively changed carbon ions are attracted to and stick to the target 18 acting as a cathode. Without the presence of argon ions this would result in growth of a carbon layer on the target 18. The possitively charged argon ions sputter both these newly deposited carbon molecules and silicon molecules from the target 18. Sputtered molecules of carbon and silicon land and adhere to the substrate 19 gradually building up a layer 24 of $Si_xC_{1-x}$. The value of x is adjustable by adjusting the argon: butane ratio inputs. When the required thickness has grown the glow discharge is stopped and the substrate allowed to cool.

For a D.C. generated plasma the supply is typically at 2 k.volts.

An electrical bias may be applied to the substrate during growth of the layer 24.

If a self supporting layer of SiC is required the aluminium substrate is etched away leaving a $Si_xC_{1-x}$ layer. Providing growth conditions were correct the $Si_xC_{1-x}$ layer is transparent to radiation in the 3-5 $\mu$m waveband.

A layer of SiC may be required as a thin (e.g. 1 $\mu$m) coating on ZnS or ZnSe lenses. Being hard SiC forms an excellent abrasion resistant protective layer that is transparent at 3-5 $\mu$m wavelengths. For coating surfaces the substrate may be temporarily connected as a cathode and argon gas only admitted to the chamber. A glow discharge is formed and the substrate cleaned. After a suitable time of cleaning the glow discharge is stopped and the above process is started.

Coatings of e.g. 1 $\mu$m thick $Ge_xC_{1-x}$ on Ge, ZnS, or ZnSe may be made as above using a target material of Ge. Similarly self supporting layers of GeC may be grown on aluminium substrates which are subsequently etched away. Providing the correct growth conditions are observed the $Ge_xC_{1-x}$ is optically transparent in the 3-5 and 10-14 $\mu$m wavelength band. It is hard and may be used alone or as a protective coating. As before the value of x in the grown layer is controlled by controlling the proportion of Ar and butane gasses. Again the value of x may vary. For example when coating germanium lenses the value of x may initially be close to 1 and then gradually changed towards zero. This may assist bonding.

When growing layers of more than two materials one material may be introduced from an ion beam source or molecular beam source.

Claims:

1.    A method of growing a combined layer of at least a first and a second material comprising the steps of arranging a first material forming a target material on a cathode in a glow discharge chamber, arranging a substrate to be coated on a holder a spaced distance from the target, maintaining the substrate temperature at a required level, admitting elements of the second material and a sputtering material into the chamber, and establishing a glow discharge within the chamber, the glow discharge plasma containing ions of the second material for adhering to the target material and ions of the sputtering material that sputter off both the first material and second material onto the substrate where a layer of the first and second material gradually builds up in thickness to the required value.

2.    The method of claim 1 wherein the sputtering material is Ar.

3.    The method of claim 1 wherein the first material forming a target material is bulk Ge, Si, or W.

4.    The method of claim 1 wherein the second material is a hydrocarbon gas.

5.    The method of claim 1 wherein the substrate is maintained at a temperature above 400°C during growth.

6.      The method of claim 1 wherein an electrical bias is applied to the substrate.

7.      The method of claim 1 and comprising the additional step of introducing a gas of the first material into the chamber and ionising said gas.

8.      The method of claim 1 wherein the substrate and target are rotated relative to one another during growth.

9.      The method of claim 1 and further comrpsing the step of removing the substrate from the grown layer.

10.     The method of claim 1 wherein the proportions of Ar and hydrocarbon gas are varied to vary the value of x in the growing layer.

11.     The method of claim 1 wherein the substrate material is infra red transparent ZnS or ZnSe and the grown layer is infra red transparent $Si_xC_{1-x}$.

12.     The method of claim 1 wherein the substrate material is infra red transparent Ge and the grown layer is infra red transparent $Ge_xC_{1-x}$.

Fig.1.

Fig.2.

**European Patent Office**

## EUROPEAN SEARCH REPORT

Application number

| | DOCUMENTS CONSIDERED TO BE RELEVANT | | EP 83306058.5 |
|---|---|---|---|
| Category | Citation of document with indication, where appropriate, of relevant passages | Relevant to claim | CLASSIFICATION OF THE APPLICATION (Int. Cl. ³) |
| D,A | GB - A - 2 083 841 (THE SECRETARY OF STATE FOR DEFENCE)<br><br>  * Page 1, lines 46-60; claims *<br><br>-- | 1,2,4, 7,11 | C 23 C 11/00<br>C 23 C 11/08//<br>G 02 B 1/10<br>G 02 B 1/12 |
| D,A | GB - A - 2 082 562 (THE SECRETARY OF STATE FOR DEFENCE)<br><br>  * Page 2 *<br><br>-- | 1,4,7, 12 | |
| A | GB - A - 2 081 695 (AVCO CORPORA-TION)<br><br>  * Claims *<br><br>-- | 1,4,7, 10,11 | |
| D,A | GB - A - 2 069 008 (THE SECRETARY OF STATE FOR DEFENCE)<br><br>  * Abstract; fig. 1; claims *<br><br>-- | 1,4,6, 7,11, 12 | |
| D,A | GB - A - 2 067 304 (NATIONAL RESEARCH DEVELOPMENT CORP.)<br><br>  * Claims *<br><br>-- | 1,4 | **TECHNICAL FIELDS SEARCHED (Int. Cl. ³)**<br><br>C 23 C<br>G 02 B |
| A | GB - A - 1 560 110 (AVCO CORPORA-TION)<br><br>  * Claims *<br><br>-- | 1,4,7, 10,11 | |
| A | US - A - 4 127 659 (H.E. DE BOLT et al.)<br><br>  * Column 3, lines 54-68; claims *<br><br>-- | 1,4,7, 10,11 | |

The present search report has been drawn up for all claims

| Place of search | Date of completion of the search | Examiner |
|---|---|---|
| VIENNA | 14-12-1983 | SLAMA |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82

**European Patent Office**

**EUROPEAN SEARCH REPORT**

| | DOCUMENTS CONSIDERED TO BE RELEVANT | | CLASSIFICATION OF THE APPLICATION (Int. Cl.³) |
|---|---|---|---|
| Category | Citation of document with indication, where appropriate, of relevant passages | Relevant to claim | |
| A | PATENT ABSTRACTS OF JAPAN, unexa-mined applications, C section, vol. 3, no. 19, February 17, 1979 THE PATENT OFFICE JAPANESE GOVERNMENT page 142 C 37 <br><br> * Kokai no. 53-144 891 (NIPPON DENSHIN DENWA KOSHA) * <br><br> -- | 1,4,6, 7,11 | |
| A | PATENT ABSTRACTS OF JAPAN, unexa-mined applications, C field, vol. 6, no. 261, December 21, 1982 THE PATENT OFFICE JAPANESE GOVERNMENT page 150 C 141 <br><br> * Kokai no. 57-155 365 (MITSUBISHI KINZOKU K.K.) 25-09-1982 * <br><br> ----- | 1,4,7, 11 | TECHNICAL FIELDS SEARCHED (Int. Cl.) |